# EUROPÄISCHE PATENTANMELDUNG

(11) **EP 2 273 859 A2**
(43) Veröffentlichungstag der Anmeldung: **12.01.2011**
(21) Anmeldenummer: 10181790.6
(22) Anmeldetag: 13.05.2008
(51) Int. Cl.: H05K 5/00, B60R 16/023, F16H 61/00

(54) **Verwendung eines Steuermoduls für eine in einem Automatikgetriebe verbaute Getriebesteuerung**

(30) Priorität: 28.06.2007 DE 102007029913
(62) Teilanmeldung aus: 08759525.2
(71) Anmelder: Robert Bosch GmbH, 70442 Stuttgart (DE)
(72) Erfinder: Becker, Rolf, 72793, Pfullingen (DE); Lammers, Christian, 70499, Stuttgart (DE); Jerg, Juergen, 72131, Ofterdingen (DE); Wolff, Joachim, 72820, Sonnenbuehl (DE); Hochholzer, Volker, 71292, Friolzheim (DE); Trescher, Ulrich, 72072, Tuebingen (DE); Bubeck, Helmut, 71717, Beilstein (DE); Voigtlaender, Klaus, 73117, Wangen (DE); Benzler, Jan, 72124, Pliezhausen (DE); Raica, Thomas, 72379, Hechingen (DE); Kuehn, Willi, 71706, Markgroeningen (DE); Wiesa, Thomas, 71665, Vaihingen (DE); Krapp, Michael, 72770, Reutlingen (DE)

(57) **Zusammenfassung**

Die Erfindung betrifft die Verwendung eines Steuermoduls (1) mit mindestens einem Gehäuseteil (3,4) und einer Mehrlagenleiterplatte (2) als elektrische Verbindung zwischen dem Gehäuseinnenraum und außerhalb des Gehäuseteils (3,4) liegenden Komponenten (6, 7, 8), wobei die Mehrlagenleiterplatte (2) Träger für die elektrischen Bauelemente (11) einer elektronischen Schaltung (9) ist und gleichzeitig thermische Kontaktierung (25, 26) an ein Gehäuseteil (3,4) und/oder einen Kühlkörper (10), insbesondere eine Hydraulikplatte des Getriebes ist, für eine in einem Automatikgetriebe verbaute Getriebesteuerung.

## Beschreibung

### Stand der Technik

Die Erfindung betrifft die Verwendung eines Steuermoduls für eine in einem Automatikgetriebe verbaute Getriebesteuerung.

Ein aus der DE 40 23 319 C1 bekanntes Steuergerät weist ein Leiterbahnsubstrat in Form einer auf eine Platte auflaminierten flexiblen Leiterbahnfolie auf. Das Leiterbahnsubstrat ist beidseitig mit elektrischen Bauelementen bestückt, die eine elektronische Schaltung bilden. Die Bauelemente sind durch zwei auf der Oberseite und der Unterseite des Leiterbahnsubstrats aufgebrachte Gehäuseteile abgedeckt. Außerhalb des durch die Gehäuseteile abgedeckten Bereichs des Leiterbahnsubstrats ist ein Gerätesteckerteil auf dem Leiterbahnsubstrat angeordnet, das über Leiterbahnen des Leiterbahnsubstrats mit den Bauelementen verbunden ist und zum Anschluss des Steuergerätes an einen externen Kabelbaum dient. Das bekannte Steuergerät ist zum Einbau in den Motorraum eines Fahrzeuges bestimmt.

Ferner ist aus der DE 195 28 632 A1 ein Steuergerät bekannt, das ein mit elektrischen Bauelementen bestücktes Leiterbahnsubstrat aufweist, das auf der Oberseite und der Unterseite mit Gehäusehalbschalen abgedeckt ist. Die Halbschalen sind durch schraubbare Befestigungsmittel an dem Leiterbahnsubstrat befestigt. Ein auf das Leiterbahnsubstrat bestücktes Leistungsbauelement erzeugt im Betrieb Wärme, die über Durchkontaktierungen unter dem Leistungsbauelement auf eine wärmeleitende Schicht auf der Unterseite des Leiterbahnsubstrats und von dort auf ein damit in Kontakt stehendes Gehäuseteil abgeführt wird.

Außerdem ist aus der WO 2006/066983 ein als Steuermodul ausgebildetes elektrisches Steuergerät für ein Getriebe bekannt, bei dem ein Gerätestecker und ein Sensor an einem Träger angeordnet sind, deren elektrische Anschlüsse über eine flexible Leiterfolie in einen Gehäuseinnenraum geführt und dort über Drahtverbindungen mit einem separat hergestellten Schaltungsteil kontaktiert sind.

### Offenbarung der Erfindung

### Vorteile der Erfindung

Erfindungsgemäß wird die Verwendung eines Steuermoduls für eine in einem Automatikgetriebe verbaute Getriebesteuerung vorgeschlagen. Das Steuermodul ist für den Anbau an ein Automatikgetriebe in besonders kostengünstiger und einfacher Herstellungsweise geeignet. Steuergeräte die in Automatikgetrieben verbaut werden, werden neben dem Gerätestecker und einem elektronischen Schaltungsteil aus miteinander verbundenen elektrischen Bauelementen mit einer Vielzahl weiterer elektrischer Komponenten kontaktiert, wie beispielsweise Aktuatoren und/oder Sensoren. Das vorgesehne Steuermodul weist vorteilhaft nur ein einziges gemeinsames Leiterbahnsubstrat auf. Hierbei handelt es sich um eine Mehrlagenleiterplatte. Die Leiterbahnen des Leiterbahnsubstrats sind nicht nur zur elektrischen Verbindung derjenigen elektrischen Bauelemente dienen, die auf dem Leiterbahnsubstrat ein durch Gehäuseteile abgedecktes elektronisches Schaltungsteil bilden, sondern auch zur Verbindung des Schaltungsteil mit weiteren elektrischen Komponente dienen, außerhalb des durch das Gehäuseteil oder, falls mehrere Gehäuseteile vorgesehen sind, außerhalb des durch die Gehäuseteile abgedeckten Teils des Leiterbahnsubstrats.

Wenigstens eine Kontaktstelle kann vorteilhaft mit einem auf das Leiterbahnsubstrat aufgebrachten Sensoranschlussteil elektrisch verbunden sein. Darüber hinaus ist es möglich, wenigstens eine Kontaktstelle auf dem Leiterbahnsubstrat außerhalb des durch die Gehäuseteile abgedeckten Bereichs vorzusehen, die mit einem elektrohydraulischen Aktuator, beispielsweise einem elektrisch betätigbaren Druckregelventil, oder einem Gegenkontakt einer anderen Getriebekomponente elektrisch verbunden ist.

Elektrische Komponenten, wie beispielsweise ein Sensoranschlussteil, können vorteilhaft außerhalb des durch die Gehäuseteile abgedeckten Bereichs des Leiterbahnsubstrats direkt auf diesem angeordnet sein. Andere Kontaktstellen auf dem Leiterbahnsubstrat außerhalb des durch die Gehäuseteile abgedeckten Bereichs können mit räumlich entfernt von dem Leiterbahnsubstrat angeordneten Aktuatoren elektrisch verbunden sein. Besonders vorteilhaft ist es, dass die nicht durch das wenigstens eine Gehäuseteil und das Gerätesteckerteil und die wenigstens eine Kontaktstelle abgedeckten äußeren Bereiche des Leiterbahnsubstrats mit einer Schutzbeschichtung versehen sind. Ein plattenförmiges Leiterbahnsubstrat mit einer ersten Seite und einer von der ersten Seite abgewandte zweite Seite und einer umlaufenden Stirnseite kann vorteilhaft als Schutzbeschichtung eine auf die erste Seite und die zweite Seite aufgebrachte Schutzschicht und eine auf die umlaufende Stirnseite aufgebrachte Kantenabdeckung umfassen. Die Schutzbeschichtung kann eine Kupferschicht, eine Lackierung oder andere geeignete Passivierungsschicht umfasst, die eine Diffusion von Getriebeöl, Wasser und anderen schädlichen Medien in das Substrat vorteilhaft verhindert.

Zur Verbesserung der Wärmeabfuhr kann wenigstens ein Gehäuseteil mit einer ebenen Fläche zur Auflage auf einen zur Wärmeabfuhr vorgesehenen Kühlkörper, insbesondere eine Hydraulikplatte eines Kraftfahrzeuggetriebes, ausgebildet sein.

Eine weitere Verbesserung der Wärmeabfuhr resultiert daraus, dass wenigstens ein auf einer ersten Seite des Leiterbahnsubstrats angeordnetes, Wärme erzeugendes elektrisches Bauelement über Durchkontaktierungen des Leiterbahnsubstrats mit einer wärmeleitenden Schicht auf einer von der ersten Seite abgewandten zweiten Seite des Leiterbahnsubstrats thermisch verbunden ist. Zur weiteren Verbesserung der Wärmeableitung steht die wärmeleitende Schicht mit einem Gehäuseteil und/oder einem Kühlkörper in Wärmeleitkontakt.

### Kurze Beschreibung der Zeichnungen

Ausführungsbeispiele der Erfindung sind in den Zeichnungen dargestellt und werden in der nachfolgenden Beschreibung näher erläutert. Es zeigen
- Figur 1: einen Querschnitt durch ein auf eine Hydraulikplatte eines Getriebes montiertes erfindungsgemäßes elektrisches Steuergerät mit daran angeordneten Sensoren und Aktuatoren,
- Figur 2: eine Draufsicht auf das Leiterbahnsubstrat des Steuergeräts ohne Sensoren, Aktuatoren und Gehäuseteile,
- Figur 3: ein vergrößertes Detail aus Fig. 1,
- Figur 4: einen Detail eine Querschnitts des Leiterbahnsubstrats nach einem anderen Ausführungsbeispiel der Erfindung,
- Figur 5: einen Querschnitt durch ein weiteres Ausführungsbeispiel der Erfindung, wobei das Gerätesteckerteil der Einfachheit halber nicht dargestellt ist,
- Figur 6: ein Detail eines vierten Ausführungsbeispiels,
- Figur 7: ein Detail eines fünften Ausführungsbeispiels.

### Ausführungsformen der Erfindung

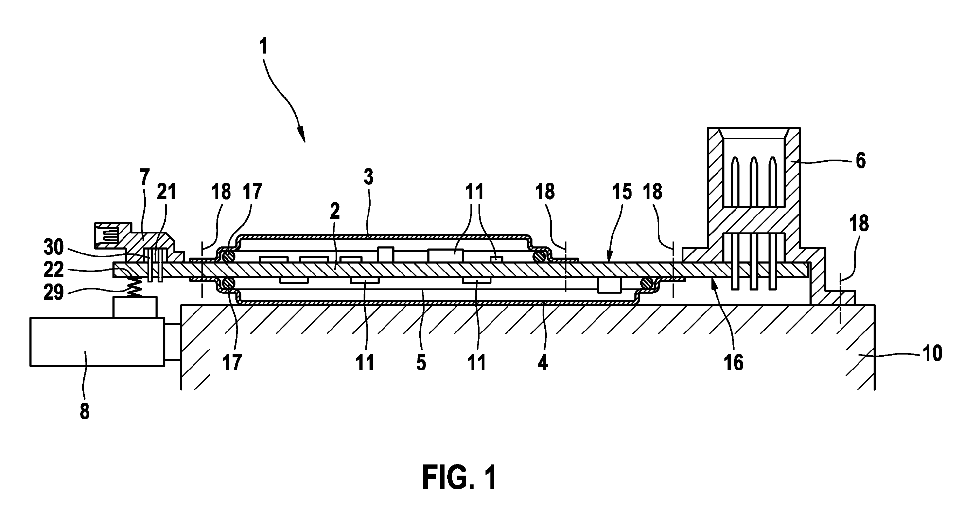

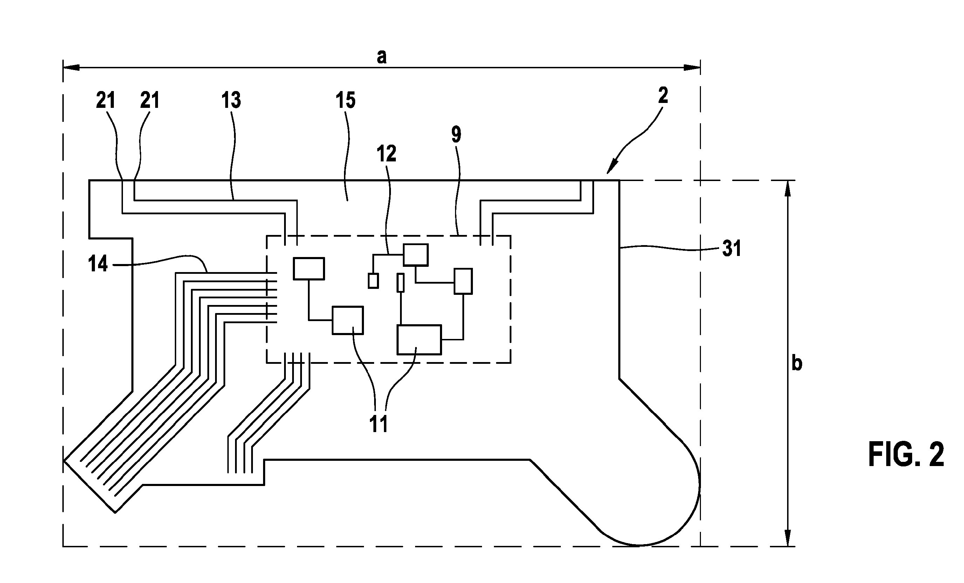

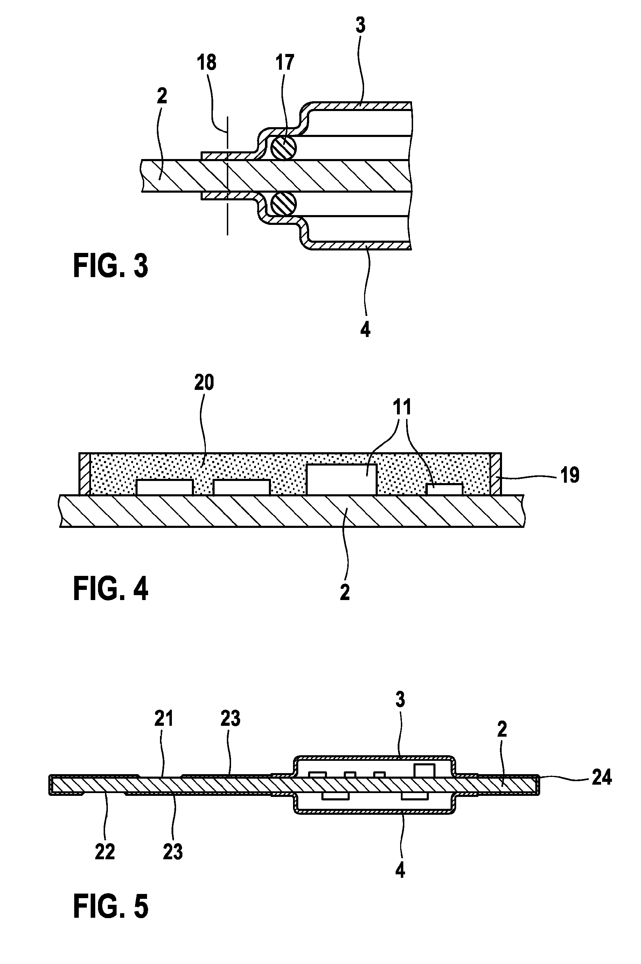

Figur 1 zeigt einen Querschnitt durch ein erstes Ausführungsbeispiel der Erfindung. Das erfindungsgemäße elektrische Steuergerät 1 umfasst ein Leiterbahnsubstrat 2. Dieses kann als Einlagenleiterplatte oder Mehrlagenleiterplatte oder als eine auf eine Metallplatte auflaminierte flexible Leiterfolie oder als Spritzgussteil mit darin eingebetteten Leiterbahnen oder in sonstiger Weise ausgebildet sein. Das Leiterbahnsubstrat ist im wesentlichen plattenförmig mit einer ersten Seite 15 und einer davon abgewandten zweiten Seite 16 und einer umlaufenden Stirnseite 31 ausgebildet. Auf der ersten Seite 15 und der zweiten Seite 16 ist das Leiterbahnsubstrat 2 in einem lokal begrenzten Bereich mit elektrischen Bauelementen 11 versehen, die eine elektronische Schaltung 9 bilden. Die Bauelemente 11 können natürlich auch nur auf einer Seite des Leiterbahnsubstrats aufgebracht sein. Der mit den Bauelementen 11 bestückte Bereich ist in Figur 2 durch die gestrichelte Linie gekennzeichnet. Die elektrischen Bauelemente 11 sind durch Leiterbahnen 12 des Leiterbahnsubstrats 2 elektrisch miteinander verbunden. Die Leiterbahnen können über eine oder mehrer Lagen des Mehrlagensubstrats geführt sein. Außer den Leiterbahnen 12 zur Verdrahtung der Bauelemente 11 sind weitere Leiterbahnen 13 und Leiterbahnen 14 auf dem Leiterbahnsubstrat angeordnet, die zu entlegenen Bereichen des Leiterbahnsubstrats 2 außerhalb des mit der elektronischen Schaltung 9 belegten Bereichs auf der ersten Seite 15 und der zweiten Seite 16 führen. Wie in Figur 2 zu erkennen ist, weist das Leiterbahnsubstrat eine maximale Länge a und eine maximale Breite b auf, die so bemessen sind, das möglichst wenig Materialverschnitt entsteht. Die Flächenausdehnung des Leiterbahnsubstrats 2 ist den Gegebenheiten in einem Kraftfahrzeuggetriebe angepasst. Wie in Figur 1 zu erkennen ist, sind die zur elektronischen Schaltung 9 gehörenden Bauelemente 11 auf der ersten Seite 15 mit einem Gehäuseteil 3 abgedeckt, während Bauelemente 11 auf der zweiten Seite 16 mit einem zweiten Gehäuseteil 4 abgedeckt sind. Die Gehäuseteile 3, 4 können beispielsweise als metallische Halbschalenteile, beispielsweise als Stanzbiegeteile ausgebildet sein. Wie am besten in Figur 3 zu erkennen ist, kann das erste Gehäuseteil 3 und das zweite Gehäuseteil 4 in bekannter Weise im Randbereich mehrfach abgewinkelt sein, so dass jeweils ein umlaufender Dichtring 17 zwischen dem abgewinkelten Bereich des jeweiligen Gehäuseteils und dem Leiterbahnsubstrat 2 angeordnet werden kann. Mittels Schraubverbindungen 18 oder in sonstiger geeigneter Weise kann das erste Gehäuseteil 3 und das zweite Gehäuseteil 4 an dem Leiterbahnsubstrat 2 befestigt werden, wobei der jeweilige umlaufende Dichtring 17 zwischen dem zugeordneten Gehäuseteil und dem Leiterbahnsubstrat 2 zusammengepresst und die elektronische Schaltung 9 nach außen abgedichtet wird.

Die Leiterbahnen 14 des Leiterbahnsubstrats 2 verbinden die elektrischen Bauelemente 11 mit einem Gerätesteckerteil 6, das außerhalb des durch die Gehäuseteile 3, 4 abgedeckten Bereichs auf dem Leiterbahnsubstrat angeordnet ist. Das Gerätesteckerteil 6 dient zum Anschluss des Steuergerätes 1 an einen externen Kabelbaum. Wichtig ist, dass außerhalb des durch die Gehäuseteile 3, 4 abgedeckten Bereichs und außerhalb des durch das Gerätesteckerteil 6 abgedeckten Bereichs auf dem Leiterbahnsubstrat 2 wenigstens eine Kontaktstelle 21 angeordnet ist, die zur Kontaktierung einer weiteren elektrischen Komponente des Steuergerätes dient. Die wenigstens eine Kontaktstelle 21 kann beispielsweise in Form einer metallisierten Fläche oder einer Durchkontaktierung ausgebildet sein.

Wie in Figur 1 gezeigt ist, kann es sich bei der weiteren Komponente beispielsweise um ein Sensoranschlussteil 7 handeln. Das Sensoranschlussteil 7 dient zum Anschluss an einen Drehzahlsensor und ist mittels zweier Kontaktstifte 30 mit zwei Kontaktstellen 21 auf dem Leiterbahnsubstrat elektrisch verbunden. Die Kontaktstellen 21 sind über Leiterbahnen 13 mit der elektronischen Schaltung 9 verbunden sind, wie dies in Figur 2 dargestellt ist. Das Sensoranschlussteil 7 kann mechanisch an dem Leiterbahnsubstrat 2 außerhalb des durch die Gehäuseteile 3, 4 und das Gerätesteckerteil abgedeckten Bereichs befestigt sein. Wie in Figur 1 weiterhin zu erkennen ist, ist auf der zweiten Seite des Leiterbahnsubstrats wenigstens eine weitere Kontaktstelle 22 angeordnet, die mittels eines elektrisch leitfähigen Federkontaktelementes 29 mit einem elektrohydraulischen Aktuator verbunden ist. Der elektrohydraulische Aktuator 8 kann beispielsweise ein Druckregelventil sein, das den Hydraulikdruck in einer Hydraulikleitung des Getriebes reguliert. Auf dem Leiterbahnsubstrat 2 können außerhalb der durch die Gehäuseteile 3, 4 und das Gerätesteckerteil 6 abgedeckten Bereiche beliebig viele andere Kontaktstellen zur Kontaktierung von elektrischen Komponenten des Getriebes, wie beispielsweise Sensoren, Aktuatoren, Klemmkontakten und Andrückkontakten angeordnet sein. Die Kontaktierung der Kontaktstellen mit den elektrischen Komponenten kann mittels Steckkontakten, Lötkontakten, Einpresskontakten, Federkontakten oder in sonstiger geeigneter Weise erfolgen. Alle Kontaktstellen sind über Leiterbahnen des Leiterbahnsubstrats mit der elektronischen Schaltung 9 verbunden.

Das mit den Gehäuseteilen 3, 4, dem Gerätesteckerteil 6 und den Kontaktstellen 21, 22 und gegebenenfalls elektrischen Komponenten 7 bestückte Leiterbahnsubstrat 2 ist mit einer ebenen Außenfläche des zweiten Gehäuseteils 4 auf einen Kühlkörper 10 montiert, bei dem es sich beispielsweise um die Hydraulikplatte eines Getriebes handeln kann. An der Hydraulikplatte sind mehrere Aktuatoren 8 befestigt, welche über Federkontaktelemente 29 mit zugeordneten Kontaktstellen 22 auf dem Leiterbahnsubstrat elektrische verbunden sind.

Wie in Figur 4 dargestellt ist, kann anstelle des beispielweise halbschalenförmigen Gehäuseteils 3 oder 4 auch ein mit einer Vergussmasse 20 gefülltes Rahmenteil 19 als Gehäuseteil zur Abdeckung der elektrischen Bauelemente 11 verwandt werden. Es ist aber auch möglich, die die Bauelemente 11 abdeckenden Gehäuseteile durch Moldmassen, Schäume, Gele oder in sonstiger Weise auszubilden. Wichtig ist, dass die Bauelemente 11 auf der ersten Seite 15 und die Bauelemente 11 auf der zweiten Seite 16 durch die Gehäuseteile 3, 4 vor aggressiven Medien geschützt sind.

Ein besonders bevorzugtes Ausführungsbeispiel der Erfindung ist in Figur 5 dargestellt. Dieses Ausführungsbeispiel unterscheidet sich von dem in Figur 1 dargestellten Ausführungsbeispiel dadurch, dass die nicht durch die Gehäuseteile 3, 4 abgedeckten Bereiche auf der ersten Seite 15 und der zweiten Seite 16 des Leiterbahnsubstrats 2 mit einer Schutzbeschichtung versehen sind. Hierzu ist die erste Seite 15 und die von der ersten Seite abgewandte zweite Seite 16 des Leiterbahnsubstrats 2 bis auf die mit dem nicht dargestellten Gerätesteckerteil 6, die Gehäuseteile 3, 4 und die Kontaktstellen 21, 22 belegten äußeren Bereiche mit jeweils einer großflächig aufgetragenen Schutzschicht 23 versehen. Die Schutzschicht 23 umfasst vorzugsweise eine großflächige Kupferleiterbahn, eine Lackierung oder eine geeignete harte oder weiche Beschichtung, welche die Diffusion von Medien wie z.B. Getriebeöl oder feuchter Luft in das Substrat verhindert. Auf die umlaufende Stirnseite des Leiterbahnsubstrats 2 ist als Schutzbeschichtung eine Kantenabdeckung 24 aufgebracht. Die Kantenabdeckung 24 kann durch Lacke, Moldmassen, Umspritzung oder eine andere geeignete Passivierung realisiert sein.

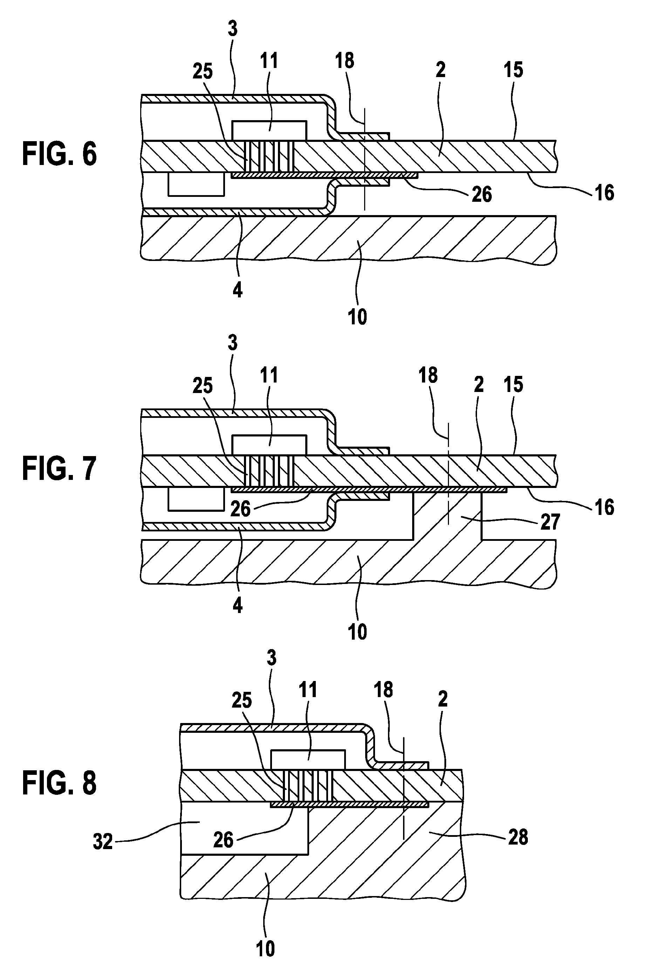

Die Wärmeabfuhr von Wärme erzeugenden Bauelementen 11 kann in verschiedener Weise vorgenommen werden. Wie in Fig. 6 dargestellt, kann die von Leistungsbauelementen 11 auf der ersten Seite 15 des Leiterbahnsubstrats 2 erzeugte Wärme beispielsweise in an sich bekannter Weise über in dem Leiterbahnsubstrat vorgesehene Durchkontaktierungen 25 auf die zweite Seite 16 abgeführt werden. Die zweite Seite 16 des Leiterbahnsubstrats 2 steht mit einer wärmeleitenden Schicht 26 in thermischen Kontakt. Die wärmeleitende Schicht 26 kann beispielsweise eine Kupferschicht sein, welche die Wärme auf das damit in Wärmeleitkontakt stehendes Gehäuseteil 4 überträgt. Von dort fließt die Wärme auf einen Kühlkörper 10 ab, auf dem das Gehäuseteil 4 aufliegt und der beispielsweise eine Hydraulikplatte des Getriebes darstellt. Die Wärme kann aber auch unmittelbar von der wärmeleitenden Schicht 26 auf den Kühlkörper 10 übertragen werden. Zu diesem Zweck kann, wie in Figur 7 dargestellt, der Kühlkörper mit einem Podest 27 versehen sein, auf dem das Leiterbahnsubstrat 2 unter Zwischenschaltung der wärmeleitenden Schicht 26 aufliegt. Alternativ kann, wie in Figur 8 dargestellt ist, der Kühlkörper 10 auch eine Aussparung 32 und einen die Aussparung 32 umgebenden Rand 28 aufweisen, auf den das Leiterbahnsubstrat 2 unter Zwischenlage der wärmeleitenden Schicht 26 aufliegt.

## Patentansprüche

1. Verwendung eines Steuermoduls (1) mit mindestens einem Gehäuseteil (3,4) und einer Mehrlagenleiterplatte (2) als elektrische Verbindung zwischen dem Gehäuseinnenraum und außerhalb des Gehäuseteils (3,4) liegenden Komponenten (6, 7, 8), **dadurch gekennzeichnet, dass** die Mehrlagenleiterplatte (2) Träger für die elektrischen Bauelemente (11) einer elektronischen Schaltung (9) ist und gleichzeitig thermische Kontaktierung (25, 26) an ein Gehäuseteil (3,4) und/oder einen Kühlkörper (10), insbesondere eine Hydraulikplatte des Getriebes ist, für eine in einem Automatikgetriebe verbaute Getriebesteuerung.

2. Verwendung nach Anspruch 1, **dadurch gekennzeichnet, dass** die Mehrlageleiterplatte (2) Durchkontaktierungen (25) zur thermischen Kontaktierung an das Gehäuseteil und/oder den Kühlkörper und zur elektronischen Anbindung an die außerhalb des Gehäuseteils (3, 4) liegenden Komponenten (6, 7, 8) aufweist.

3. Verwendung nach einem der Ansprüche 1 bis 2, **dadurch gekennzeichnet, dass** die Mehrlagenleiterplatte (2) einstückig ausgeführt ist.

4. Verwendung nach einem der vorhergehenden Ansprüche, **dadurch gekennzeichnet, dass** die elektronische Anbindung der außerhalb des Gehäuses (3, 4) angeordneten Komponenten (6, 7, 8) mittels Einpresskontakten, Lötkontakten oder Federkontakten oder in sonstiger geeigneter Weise ausgeführt wird.

5. Verwendung nach einem der vorhergehenden Ansprüche, **dadurch gekennzeichnet, dass** die elektrischen Bauelemente (11), welche die elektronische Schaltung (9) bilden, auf der Mehrlagenleiterplatte (2) aufgebracht sind.

6. Verwendung nach einem der vorhergehenden Ansprüche, **dadurch gekennzeichnet, dass** die elektrischen Bauelemente (11) der elektronischen Schaltung (9) auf der Mehrlagenleiterplatte (2) durch Moldmassen, Schäume, Gele oder in sonstiger Weise abgedeckt sind.
